# EUROPÄISCHE PATENTSCHRIFT

(11) **EP 3 000 158 B1**
(45) Veröffentlichungstag und Bekanntmachung des Hinweises auf die Patenterteilung: **10.07.2019**
(21) Anmeldenummer: 14727764.4
(22) Anmeldetag: 22.05.2014
(51) Int. Cl.: H02B 1/56, B01D 46/00, F04D 25/14, F04D 29/70, H05K 7/20, F04D 19/00, H02B 1/28

(54) **LÜFTERTRÄGER FÜR EINEN LÜFTER, INSBESONDERE EINES SCHALTSCHRANKES**
FANHOLDER FOR A FAN, ESPECIALLY OF A SWITCHGEAR ENCLOSURE.
SUPPORT DE VENTILATEUR POUR UN VENTILATEUR, SPÉCIALEMENT UN VENTILATEUR POUR ARMOIRE ÉLECTRIQUE

(30) Priorität: 22.05.2013 DE 102013105196; 31.01.2014 DE 102014101184
(43) Veröffentlichungstag der Anmeldung: 30.03.2016
(73) Patentinhaber: STEGO-Holding GmbH, 74523 Schwäbisch Hall (DE)
(72) Erfinder: SCHANZENBACH, Bernd Armin, 74535 Mainhardt Geisselhardt (DE); DENT, Robert, 74523 Schwäbisch Hall (DE); MANGOLD, Elmar, Unterschneidheim 73485 Zöbingen (DE)
(74) Vertreter: Bohnenberger, Johannes
(86) Internationale Anmeldenummer: PCT/EP2014/060550
(87) Internationale Veröffentlichungsnummer: WO 2014/187903

(56) Entgegenhaltungen:
- DE-A1- 19 700 065
- DE-A1-102010 016 504
- DE-U1-202006 010 888
- US-A1- 2002 173 265
- US-A1- 2010 003 126
- US-A1- 2013 023 199

## Beschreibung

Die Erfindung betrifft einen Lüfterträger für einen Lüfter, insbesondere eines Schaltschrankes sowie eine Lüftungseinrichtung, insbesondere für einen Schaltschrank, sowie ein Set umfassend einen Lüfterträger, mindestens eine Klappeneinrichtung und mindestens eine Filtermatte.

Im Stand der Technik sind Lüftereinrichtungen bekannt, die einen Lüfterträger umfassen, sowie einen Lüfter, der durch den Lüfterträger gehalten wird. Bei derartigen Lüftereinrichtungen wird vergleichsweise weit unten im Schaltschrank kalte Luft über eine Filtermatte eingesaugt und vergleichsweise weit oben über eine (grobe) Ausgangsfiltermatte hinausgedrückt. Dadurch soll die Einbringung von Staub vermieden werden und ein Überdruck im Schrank erzeugt werden. Die im Stand der Technik bekannten Lüfter werden als vergleichsweise ineffektiv und insbesondere als wenig variabel empfunden.

US 2002 / 173265 A1 beschreibt ein modulares Gebläsesystem mit einem Ventilator, einem Luftkammerelement, das an dem Ventilator montiert werden kann und dazu angepasst ist, an einem Gehäuse angebracht zu werden, einer Dichtung, die angepasst ist, um zwischen dem Luftkammerelement und dem Gehäuse montiert zu werden, und innerhalb des Luftkammerelements angebracht ist, und einem Gitter, das angepasst ist, um an dem Luftkammerelement montiert zu werden. Weiterhin ist ein Filter vorgesehen, der optional in das Luftkammerelement montiert werden kann. In dem System sind ein oder mehrere der zuvor genannten Teile zu einer ersten Lüfteranordnung und alternativ zu einer zweiten Lüfteranordnung zusammensetzbar.

DE 20 2006 010888 U1 bezieht sich auf eine Vorrichtung, die einen Lüfter, einen Lüfterträger, eine Filtermatte und ein Lamellenelement umfasst. Die Filtermatte und das Lamellenelement sind in dem Lüfterträger angeordnet.

US 2013 / 023199 A1 betrifft eine Lüfteranordnung mit einer Halterung, einem Lüfter und einem Käfig. Die Halterung enthält eine Belüftungsplatte. Der Ventilator ist in der Halterung aufgenommen und an der Belüftungsplatte befestigt. Der Käfig ist in der Halterung aufgenommen und am Lüfter befestigt. Der Käfig definiert eine Öffnung und enthält eine Vielzahl von Teilen, die drehbar in der Öffnung aufgenommen sind. Die Vielzahl von Teilen bedeckt die Öffnung. Der Käfig umfasst ferner eine Vielzahl von Begrenzungsstücken, die sich von einer inneren Oberfläche der Öffnung erstrecken. Der Druck der sich bewegenden Luft von dem Gebläse ist in der Lage, die Mehrzahl von Stücken zu drehen, aber jede Überdrehung der Vielzahl von Stücken wird durch die Mehrzahl von begrenzenden Stücken verhindert.

Es ist Aufgabe der Erfindung, ein Set und eine Lüfteranordnung umfassend einen Lüfterträger vorzuschlagen, wobei eine effektive Kühlung erfolgen kann, und wobei insbesondere variabel auf die Bedürfnisse des Anwenders reagiert werden kann.

Die Aufgabe wird durch ein Set gemäß Anspruch 1 und eine Lüfteranordnung gemäß Anspruch 2 gelöst, die jeweils einen Lüfterträger aufweisen.

Hierbei beschreibt die Erfindung einen Lüfterträger für einen Lüfter insbesondere eines Schaltschrankes, der einen Rahmen mit einer Öffnung aufweist, durch die im Betrieb ein gasförmiges Medium strömt, wobei die Öffnung einen Aufnahmebereich bildet, der zur Aufnahme verschiedener, austauschbarer Einsätze, insbesondere eines Filtereinsatzes und einer Klappeneinrichtung, angepasst ist und wenigstens ein Haltemittel zur Fixierung des jeweiligen Einsatzes aufweist.

Ein Kerngedanke der Erfindung liegt darin, einen Lüfterträger vorzusehen, in dem sowohl eine Klappeneinrichtung eingebracht werden kann, als auch ein Filtereinsatz. Dazu ist eine entsprechende Halteeinrichtung an dem Rahmen bzw. in dem Aufnahmebereich vorgesehen. Dadurch kann der Anwender eine Klappeneinrichtung in den Lüfterträger einsetzen. Insgesamt kann variabel auf die besonderen Bedürfnisse des Anwenders reagiert werden. In diesem Zusammenhang wurde erkannt, dass die Hauptaufgabe einer Lüftereinrichtung für Schaltschränke darin besteht, den Schaltschrank durch Luftumwälzung zu kühlen. Dabei soll die Einbringung von Staub vermieden werden. Letzteres ist jedoch nicht die Hauptaufgabe. Es wurde weiterhin erkannt, dass beim Einbau einer Filtereinrichtung im oberen Dritteln eines Schaltschrankes eine effektivere Kühlung durchgeführt werden kann. Daher wurde erwogen, die Luft nicht über eine Filtermatte aus einem Schaltschrank auszublasen (die einen reduzierten Luftdurchsatz zur Folge hätte), sondern über eine Klappeneinrichtung, die eine verbesserte Luftströmung zur Folge hat. Bei Lüftereinrichtungen im Stand der Technik wurde stets eine Filtermatte vorgesehen, um einen entsprechenden Staubschutz zu erhalten. Durch eine Montage eines Aulassfilters im oberen Bereich des Schaltschrankes (beispielsweise in der oberen Hälfte, insbesondere im oberen Drittel des Schaltschrankes) wird ein Luftstrom auf den Einlassfilter gleichmäßig verteilt, der insbesondere in der unteren Hälfte, insbesondere in einem unteren Drittel des Schaltschrankes angeordnet sein kann. Dadurch ist eine Filtermatte des Einlassfilters vergleichsweise langlebig und verschmutzt weniger stark. Dadurch, dass der Lüfterträger sowohl eine Klappeneinrichtung als auch einen Filtereinsatz aufnehmen kann, kann der Anwender des Lüfterträgers eine Auswahl treffen. Im Ergebnis kann der Anwender zwischen einer verbesserten Luftumwälzung oder einer verbesserten Staubvermeidung wählen.

Besonders bevorzugt wird ein Lüfterträger, bei dem die Öffnung seitlich durch Halteflächen begrenzt ist, die den jeweiligen Einsatz im Rahmen halten. Insbesondere umfasst der Aufnahmebereich eine Halteeinrichtung, insbesondere wenigstens ein elastisches Element oder wenigstens eine Rastnase, die im Betrieb eine Haltekraft auf den jeweiligen Einsatz ausübt. Auf diese Weise kann der Einsatz durch einen Benutzer ohne Weiteres ausgetauscht und an verschiedene Anwendungen angepasst werden. Beispielsweise kann zur Fixierung der Einsätze in dem Aufnahmebereich jeweils ein elastisches Element in den Ecken des Aufnahmebereichs angeordnet sein, die die Halteflächen verbinden.

Besonders vorteilhaft ist außerdem, wenn eine separierbare, insbesondere schwenkbar gelagerte Abdeckhaube vorgesehen ist, über die der Lüfterträger, insbesondere dessen Aufnahmebereich, nach außen verschließbar ist. Der Rahmen des Lüfterträgers bildet vorzugsweise eine, insbesondere umlaufende, Stufe aus, auf die die Abdeckhaube aufgelegt werden kann.

Das Set umfasst einen Lüfter, einen Lüfterträger, eine Klappeneinrichtung sowie einen Filtereinsatz, wobei Klappeneinrichtung und Filtereinsatz in einen selben Aufnahmebereich des Lüfterträgers aufnehmbar sind.

Die Lüftungseinrichtung dient insbesondere zur Anwendung in bzw. an einem Schaltschrank und umfasst einen Lüfterträger gemäß der Erfindung sowie einen Lüfter. Besonders vorteilhaft ist es, wenn der Lüfter über einen Lüftertrichter mit dem Lüfterträger verbunden ist. Der Lüfterträger sorgt in vorteilhafter Weise für eine Homogenisierung des Luftstroms.

Die Klappeneinrichtung ist zur Verwendung mit einem Lüfterträger vorgesehen, und umfasst einen Klappenrahmen, der in den Aufnahmebereich des Lüfterträgers einsetzbar ist und wenigstens eine, insbesondere mehrere Klappen trägt, die zur Umlenkung der Strömung den Klappenrahmen zumindest teilweise überdecken. Vorteilhafterweise sind die Klappen lösbar mit den Klappenrahmen verbunden. Weiterhin ist der Lüfterträger vorzugsweise in der oberen Hälfte des Schaltschrankes, insbesondere in einem oberen Drittel des Schaltschrankes, angeordnet.

Die Erfindung wird im Folgenden anhand der Zeichnung näher erläutert. Darin zeigen:
- Fig. 1: eine schematische Explosionsdarstellung einer Lüftungseinrichtung;
- Fig. 2: eine schematische Explosionsdarstellung eines Lüfterträgers;
- Fig. 3: eine schematische Explosionsdarstellung des Lüfterträgers mit einer Klappeneinrichtung gemäß der Erfindung;
- Fig. 4: einen Querschnitt durch ein zusammengesetztes Set, umfassend Lüfterträger mit Klappeneinsatz, Lüfter und Abdeckhaube; und
- Fig. 5: eine schematische Darstellung eines Schaltschranks mit zwei Lüftungseinrichtungen.

In der nachfolgenden Beschreibung werden für gleiche und gleich wirkende Teile dieselben Bezugszeichen verwendet.

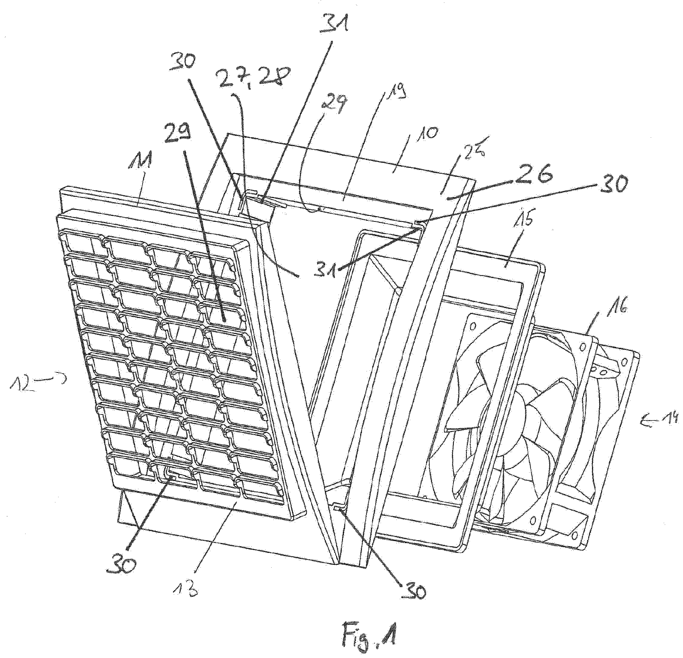

Fig. 1 zeigt eine Lüftungseinrichtung umfassend einen Lüfterträger 10 mit einer Abdeckhaube 11, die in Richtung einer Außenseite 12 mit einem Frontgitter 13 abgeschlossen ist. In Richtung einer Innenseite 14 schließt sich an den Lüfterträger 10 ein Lüftertrichter 15 an. An den Lüftertrichter 15 wiederum schließt sich ein Lüfter 16 an. Der Lüfter 16 kann insbesondere als Axiallüfter ausgebildet sein.

In einem Anwendungsbeispiel ist die Lüftungseinrichtung mit einem Schaltschrank (nicht gezeigt) verbunden. Die Lüftungseinrichtung ist dabei in eine Aussparung in einer Schaltschrankwand eingesetzt und dort durch ein geeignetes Befestigungsmittel fixiert, das sich insbesondere an dem Lüfterträger 10 befindet. Die Lüftungseinrichtung stellt somit eine Verbindung zwischen dem Inneren des Schaltschranks und dessen Außenbereich her. Je nach Drehrichtung des in dem Schaltschrank befindlichen Lüfters 16 kann Luft durch die Lüftungseinrichtung in den Schaltschrank eingesaugt oder aus diesem ausgestoßen werden.

Der Lüfterträger 10 weist einen Rahmen 26 und einen Aufnahmebereich 28 auf, der durch eine Öffnung 27 in dem Lüfterträger 10 gebildet wird. Weiterhin weist der Lüfterträger 10 eine umlaufende, innenliegende Stufe 19 auf, die an dem Rahmen 26 ausgebildet ist und an der die Abdeckhaube 11 im geschlossenen Zustand des Aufnahmebereichs 28 anliegen kann.

In den Aufnahmebereich 28 des Lüfterträgers 10 können verschiedene Einsätze eingesetzt und dort durch geeignete Haltemittel fixiert werden. Insbesondere wird die Öffnung 27 durch Halteflächen 29 begrenzt, die den jeweiligen Einsatz im Rahmen halten. Zur Fixierung eines jeweiligen Einsatzes in dem Aufnahmebereich 28 können im Übrigen spezielle Halteeinrichtungen vorgesehen sein. Dabei kann es sich beispielweise um Rast-, Klipp-, Gummi- oder Magnetelemente handeln. In der in Fig. 1 gezeigten Ausführungsform der Erfindung wird ein Einsatz durch elastische Elemente 30 gehalten, die eine Haltekraft auf den Einsatz ausüben. Die elastischen Elemente 30 sind in Ecken 31 des Aufnahmebereichs 28 angeordnet und verbinden auf diese Weise die Halteflächen 29 miteinander.

Der Aufnahmebereich 28 ist mittels der Abdeckhaube 11 verschließbar. In einem geöffneten Zustand ermöglicht die Abdeckhaube 11 den Zugang zu dem Aufnahmebereich 28. Die Abdeckhaube 11 ist abnehmbar, vorzugsweise schwenkbar an dem Lüfterträger 10, insbesondere an einer im montierten Zustand der Lüftungseinrichtung dem Boden zugewandten Kante des Rahmens 26, befestigt. Die Abdeckhaube 11 ist durch geeignete Schnapp- und/oder Rastmittel o. dgl. an dem Lüfterträger 10 in einer geschlossenen Position arretierbar. Vorzugsweise ist der maximale Öffnungswinkel der Abdeckhaube 11 bzgl. des Rahmens 26 durch geeignete Begrenzungselemente vorbestimmt. Auf diese Weise ist insgesamt ein besonders einfacher Austausch der Einsätze im Bedarfsfall möglich.

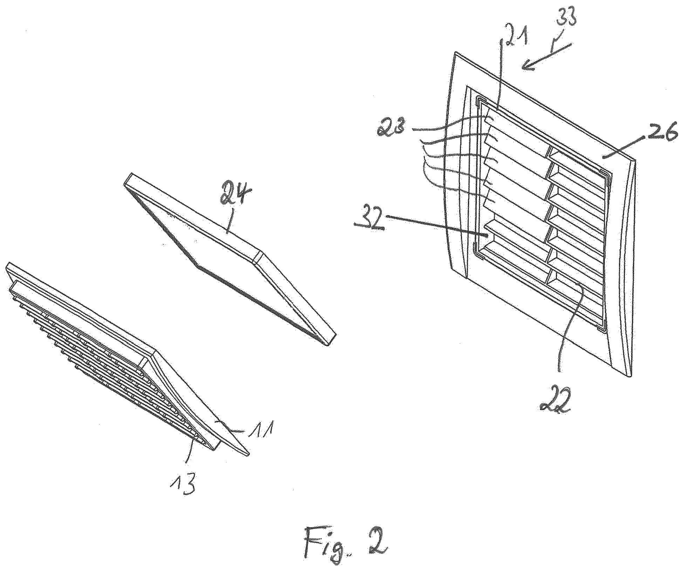

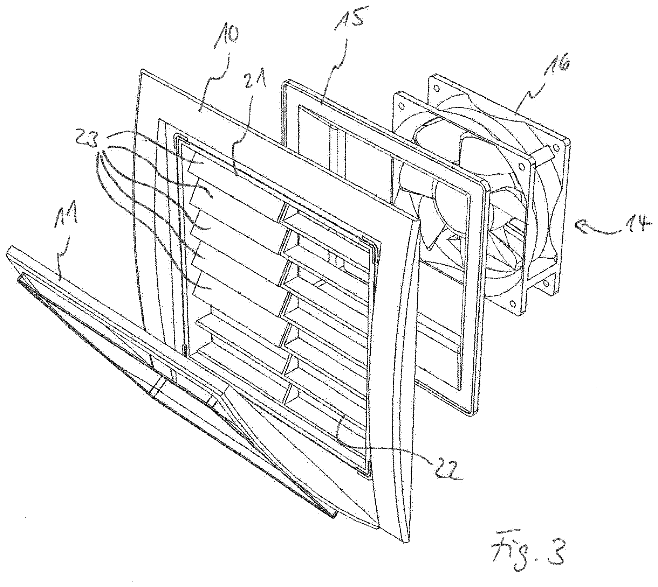

Wie in Fig. 2 und Fig. 3 dargestellt, kann in dem Aufnahmebereich 28 eine Klappeneinrichtung 21 als austauschbarer Einsatz montiert werden. Die Klappeneinrichtung 21 umfasst einen Klappenrahmen 32 und Klappenhaltestege 22 sowie eine Vielzahl von Klappen (Lamellen) 23 (von denen der besseren Übersicht halber nur fünf dargestellt sind). Die Klappen (Lamellen) 23 sind schwenkbar an den Haltestegen 22 gelagert, insbesondere angeklippt, und können durch ausströmende Luft aus der Richtung des Pfeils 33 verschwenkt werden. Es ist denkbar, dass auch eine aktive Verschwenkungseinrichtung (beispielsweise elektromotorisch) vorgesehen ist. Im montierten Zustand liegt der Klappenrahmen 32 mit einer Außenfläche vorzugsweise an den Halteflächen 29 an.

Alternativ zu der Klappeneinrichtung 21 kann als auswechselbarer Einsatz auch ein Filtereinsatz 24 (s. Fig. 2) verwendet werden, der in den Aufnahmebereich 28 eingesetzt wird. Bei dem Filtereinsatz kann es sich beispielsweise um eine Filtermatte oder dergleichen geeignetes Filterelement handeln. Während der Hauptzweck des Filtereinsatzes das Herausfiltern von Partikeln, wie Staub o. dgl. ist, dient die Klappeneinrichtung 21 zur Realisierung eines erhöhten Luftdurchsatzes ohne eine Filterung der durch die Klappeneinrichtung 21 strömenden Luft. Ein Endbenutzer der Lüftungseinrichtung kann folglich selber entscheiden, ob er den Lüfterträger mit einer Klappeneinrichtung zur optimierten Luftumwälzung/Kühlung in einem Schaltschrank, oder zur optimierten Staubvermeidung mit einem Filtereinsatz ausrüstet.

Das Frontgitter 13 kann auch als Netz oder aus dergleichen luftdurchlässigem Material ausgebildet sein. Es kann darüber hinaus, beispielsweise für Reinigungs- oder Austauschzwecke, lösbar von der Abdeckhaube 11 ausgebildet sein. Ohne das Frontgitter 13 bildet die Abdeckhaube 11 einen rechteckigen (umlaufenden) Rahmen aus (mit zwei gerade verlaufenden Kanten und zwei gebogenen Kanten, wobei sich die gerade verlaufenden und die gebogenen Kanten jeweils gegenüberliegen). Auf ähnliche Weise bildet auch ein Hauptkörper 25 des Lüfterträgers 10 einen umlaufenden (rechteckförmigen) Rahmen aus. Zwei sich gegenüberliegende Seiten des Hauptkörpers 25 sind gerade ausgebildet; die anderen, sich gegenüberliegenden Seiten gebogen. Im montierten Zustand der Abdeckhaube 11 fluchten die gebogenen Seiten mit den gebogenen Seiten des Hauptkörpers 25 des Lüfterträgers 10. Dadurch wird eine homogene Einheit erreicht.

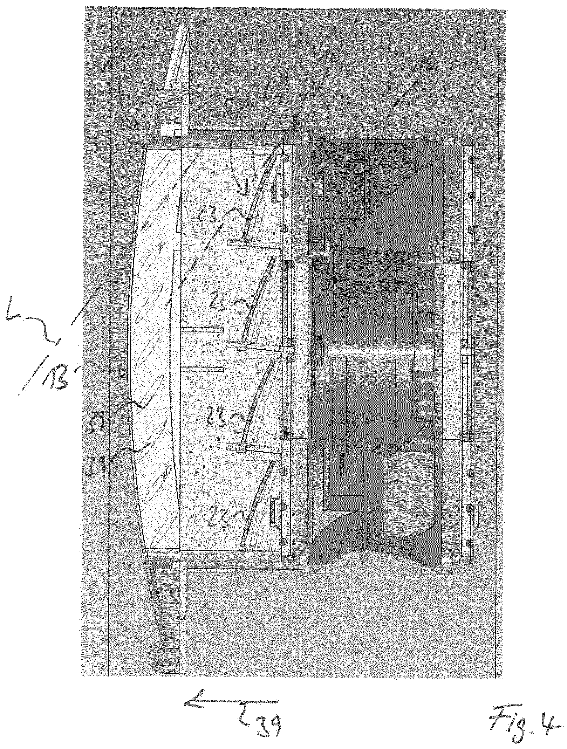

Die Fig. 4 zeigt noch einen Querschnitt durch ein zusammengesetztes Set, das einen Lüfterträger 10 mit einem Klappeneinsatz 21, einen Lüfter 16 und eine Abdeckhaube 11 umfasst. Die Fig. 4 macht deutlich, dass die Abdeckhaube 11 und das darin aufgenommene Frontgitter 13 dem Lüfterträger 10 in Richtung der Luftaustrittsrichtung 39 vorgelagert ist. Diese vorgelagerte Anordnung der Abdeckhaube 11 und des Frontgitters 13 verhindert in vorteilhafter Weise, dass durch eine oder mehrere geöffnete Klappe(n) 23, Fremdkörper, insbesondere Wasser, in die Lüftungseinrichtung eintritt.

Insbesondere ist das Frontgitter 13 in der in Fig. 4 gezeigten Ausführungsform als Diffusor ausgebildet, der den Eintritt von Flüssigkeit, z.B. bei Regen, in das Innere der Lüftungseinrichtung und insbesondere in den Lüfter verhindert. Bei einem stillstehenden Lüfter 16 besteht nämlich die Gefahr, dass sich die Klappen 23 durch einen z.B. Luftzug induzierten Unterdruck oder durch eine mechanische Blockade öffnen, wobei folglich das Schaltschrankinnere bei stehendem Lüfter 16 offen ist und Schmutz, Wasser etc. eindringen könnten. Der Diffusor ist so ausgeführt, dass er Normengerecht, insbesondere in Bezug auf die Sicherheitsanforderungen ist und eine ideale Strömungsform für den Luftaustritt aufweist. Wie die Fig. 4 zeigt, weist das Frontgitter 13 hierzu mehrere Durchgangsschlitze 39 auf, die insbesondere einen ovalen bzw. elliptischen Querschnitt aufweisen. Die Längsachse L der Durchgangsschlitze 39 ist bezüglich der Klappen 23 derart ausgerichtet, dass sie im Wesentlichen parallel zu den Klappen 23 in (maximal) geöffnetem Zustand (s. Linie L' in Fig. 4) ausgerichtet ist. Auf diese Weise wird der Strömungswiderstand der Durchgangsschlitze 39 minimiert.

Das Frontgitter 13 kann von außen vorzugsweise nur mit einem Schraubenzieher geöffnet werden und von der Innenseite durch eine Blockade des Riegels verschlossen werden. Damit wird ein einfacher Vandalen-Schutz realisiert. Weiterhin ist das Frontgitter 13 vorzugsweise drehbar im Rahmen der Abdeckhaube 11 gelagert, um Servicearbeiten zu ermöglichen.

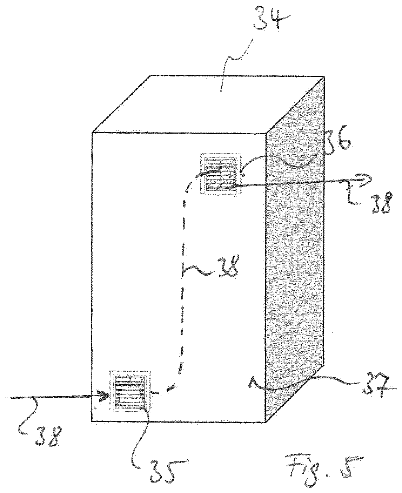

Die Fig. 5 zeigt noch einen schematischen Anwendungsfall der Erfindung mit einem Schaltschrank 34 und zwei Lüftungseinrichtungen 35 und 36. Während die untere, bodennahe Lüftungseinrichtung 35 die Schaltschrankwand 37 in einem unteren Drittel durchgreift, ist die zweite Lüftungseinrichtung 36 in einem oberen Drittel der Schaltschrankwand 37 angeordnet. Es versteh sich, dass die beiden Lüftungseinrichtungen nicht in derselben Schaltschrankwand angeordnet sein müssen.

Vorteilhafterweise kann vorgesehen sein, dass die erste untere Lüftungseinrichtung 35 eine Einlass-Lüftungseinrichtung bildet, die über einen Filtereinsatz, z.B. eine Filtermatte, in dem Aufnahmebereich 28 verfügt und bei der ein Lüfter Luft in den Schaltschrank 34 zur Erzeugung eines Überdrucks einsaugt. Durch den Überdruck in dem Schaltschrank soll verhindert werden, dass Partikel, insbesondere Staub oder dergleichen durch Türen, Kabeldurchführungen oder sonstige Öffnungen in den Schaltschrank eintreten.

Während im Stand der Technik auch die obere Lüftungseinrichtung 36 bislang mit einem Filtereinsatz ausgerüstet war, um einen Eintritt von Partikeln in den Schaltschrank weiter zu reduzieren, kann die Lüftungseinrichtung 36 in vorteilhafter Weise eine in Fig. 2 und Fig. 3 gezeigte Klappeneinrichtung 21 in dem Aufnahmebereich 28 umfassen. Die obere Lüftungseinrichtung 36 dient als Auslass-Lüftungseinrichtung und folglich weist der Lüfter eine Drehrichtung auf, die das Ausstoßen von Luft aus dem Schaltschrank 34 bewirkt. Der durch die untere und obere Lüftungseinrichtung 35, 36 in dem Schaltschrank 34 entstehende Luftstrom ist in der Fig. 5 mit dem Pfeil 38 gekennzeichnet. Im Gegensatz zu einer Filtermatte reduziert die Klappeneinrichtung 21 den Luftdurchsatz nicht, sodass im oberen Bereich des Schaltschrankes 34 ein effektives Kühlen des Schaltschrankes ermöglicht wird. Das Resultat ist eine verbesserte Luftströmung in dem Schaltschrank, die auch den Filtereinsatz in der unteren Lüftungseinrichtung 35 schont, da der Lufteintrittssog geringer ist und somit nicht nur die dem Impeller des Lüfters 16 entsprechende Fläche des Filtereinsatzes die Luft filtert, sondern die gesamte Fläche des Filters. Dadurch wird die eingesogene Luft also insgesamt gleichmäßiger auf den Eingangsfiltereinsatz verteilt. Der Filtereinsatz ist dadurch langlebiger und eine Verschmutzung wird vermindert. Weiterhin verhindert die Klappeneinrichtung 21 in vorteilhafter Weise, dass bei stillstehendem Lüfter unerwünschte Fremdkörper, insbesondere Staub, Wasser o.dgl. in den Schaltschrank eindringen. Dieser vorteilhafte Effekt wird dadurch erreicht, dass die Klappen 23 bei stillstehendem Lüfter geschlossen sind und den Lüfter bzw. das Schaltschrankinnere damit gegen Fremdkörper abschließen. Durch die schwenkbare Lagerung der Klappen werden diese also vorzugsweise durch die Schwerkraft oder elektromotorisch im geschlossenen Zustand gehalten, wenn der Lüfter 16 ausgeschaltet ist. Nur im eingeschalteten Zustand des Lüfters werden die Klappen 23 durch den resultierenden Luftstrom in eine geöffnete Stellung verlagert.

Durch die flexiblen Einsatzmöglichkeiten und den modularen Aufbau mit Hilfe der Lüfterträger kann die vorliegende Erfindung beide Systeme problemlos realisieren: Es kann zum einen eine optimierte Staubvermeidung realisiert werden, indem auch der obere Lüfterträger 10 ohne Weiteres im Bedarfsfall mit einem Filtereinsatz 24 versehen werden kann. Darüber hinaus kann für eine optimierte Luftumwälzung und damit für eine an oberster Stelle stehende optimierte Kühlung alternativ ein Klappeneinsatz 21 in den Lüfterträger eingesetzt werden, um die oben beschriebene Wirkungsweise einer optimierten Kühlung zu erzielen.

Die Modularität des Systems ermöglicht eine besonders hohe Flexibilität, die es einem Benutzer erlaubt, den Lüfterträger individuell an bestehende Bedürfnisse anzupassen und bei Bedarf einen Austausch der Einsätze in dem Aufnahmebereich 28 besonders einfach zu bewerkstelligen.

### Bezugszeichenliste

- 10: Lüfterträger
- 11: Abdeckhaube
- 12: Außenseite
- 13: Frontgitter
- 14: Innenseite
- 15: Lüftertrichter
- 16: Lüfter
- 19: Stufe
- 21: Klappeneinrichtung
- 22: Haltestege
- 23: Klappen
- 24: Filtereinsatz
- 25: Hauptkörper
- 26: Rahmen
- 27: Öffnung
- 28: Aufnahmebereich
- 29: Halteflächen
- 30: elastisches Element
- 31: Ecken
- 32: Klappenrahmen
- 33: Pfeil
- 34: Schaltschrank
- 35: Lüftungseinrichtung
- 36: Lüftungseinrichtung
- 37: Schaltschrankwand
- 38: Pfeil
- 39: Luftaustrittsrichtung
- 40: Durchgangsschlitze
- L: Längsachse

## Patentansprüche

1. Set Folgendes umfassend:
einen Lüfter (16),
verschiedene, gegeneinander alternativ austauschbare Einsätze und einen Lüfterträger (10) für den Lüfter (16),
wobei die Einsätze einen Filtereinsatz (24) und eine zum Verschließen einer Öffnung (27) mit schwenkbar gelagerten Klappen versehene Klappeneinrichtung (21) umfassen,
wobei der Lüfterträger (10) einen Rahmen (26) mit der Öffnung (27) umfasst,
durch die im Betrieb ein gasförmiges Medium strömen kann, und die einen Aufnahmebereich (28) bildet, der zur alternativen Aufnahme der Klappeneinrichtung (21) und des Filtereinsatzes (24) ausgebildet ist und wenigstens ein Haltemittel zur Fixierung des jeweiligen Einsatzes aufweist.

2. Lüfteranordnung umfassend
einen Lüfter (16) gemäß Anspruch 1,
einen Lüfterträger (10) gemäß Anspruch 1,
eine Abdeckhaube (11), über die der Aufnahmebereich (28) des Lüfterträgers (10), z.B. durch ein Frontgitter (13), nach außen verschließbar ist,
und
eine Klappeneinrichtung (21) gemäß Anspruch 1,
wobei die Klappeneinrichtung (21) im Aufnahmebereich (28) gegen einen Filtereinsatz (24) gemäß Anspruch 1 austauschbar angeordnet ist, und wobei die Klappeneinrichtung (21) zwischen dem Lüfter (16) und der Abdeckhaube (11) angeordnet ist.

3. Set oder Lüfteranordnung nach Anspruch 1 oder 2,
**dadurch gekennzeichnet, dass**
die Öffnung (27) seitlich durch Halteflächen (29) begrenzt ist, die den jeweiligen Einsatz im Rahmen (26) halten.

4. Set oder Lüfteranordnung nach einem der Ansprüche 1-3,
**dadurch gekennzeichnet, dass**
der Aufnahmebereich (28) eine Halteeinrichtung, insbesondere wenigstens ein elastisches Element (30) oder wenigstens eine Rastnase, aufweist, die im Betrieb eine Haltekraft auf den jeweiligen Einsatz ausübt.

5. Set oder Lüfteranordnung nach Anspruch 4,
**dadurch gekennzeichnet, dass**
jeweils ein elastisches Element (30) in den Ecken (31) des Aufnahmebereichs (28) angeordnet ist, die die Halteflächen (29) verbinden.

6. Set nach einem der vorhergehenden Ansprüche,
**dadurch gekennzeichnet, dass**
eine, vorzugsweise separierbare, Abdeckhaube (11) vorgesehen ist, über die der Lüfterträger, insbesondere dessen Aufnahmebereich (28), nach außen verschließbar ist.

7. Set oder Lüfteranordnung nach Anspruch 6,
**dadurch gekennzeichnet, dass**
die Abdeckhaube (11) ein als Diffusor ausgebildetes Frontgitter (13) aufweist, das mehrere Durchgangsschlitze (39) insbesondere mit einem elliptischen Querschnitt aufweist.

8. Set oder Lüfteranordnung nach einem der vorhergehenden Ansprüche,
**dadurch gekennzeichnet, dass**
der Rahmen (26) eine, insbesondere umlaufende, Stufe (19) ausbildet, auf die die Abdeckhaube (11) aufgelegt werden kann.

9. Lüfteranordnung nach einem der vorhergehenden Ansprüche,
**dadurch gekennzeichnet, dass**
der Lüfter (16) über einen Lüftertrichter (15) mit dem Lüfterträger (10) verbunden ist.

10. Set oder Lüfteranordnung nach einem der vorhergehenden Ansprüche,
wobei die Klappeneinrichtung (21) einen Klappenrahmen (32) umfasst, der in den Aufnahmebereich (28) des Lüfterträgers einsetzbar bzw. eingesetzt ist und wenigstens eine, insbesondere mehrere Klappen (23) trägt.

11. Set oder Lüfteranordnung nach Anspruch 10,
**dadurch gekennzeichnet, dass**
die Klappen (23) in einem ausgeschalteten Betriebszustand des Lüfters (16) geschlossen sind.

12. Set oder Lüfteranordnung nach Anspruch 10 oder 11,
**dadurch gekennzeichnet, dass**
die Klappen (23) lösbar mit den Klappenrahmen (32) verbunden sind.

13. Set oder Lüfteranordnung nach einem Ansprüche 10-12,
**dadurch gekennzeichnet, dass**
eine Längsachse (L) der Durchgangsschlitze (39) im Wesentlichen parallel zu den Klappen (23) in einem geöffneten Zustand ausgerichtet ist.

14. Schaltschrank, umfassend eine Lüfteranordnung nach einem der Ansprüche 2-5, 7-13,
**dadurch gekennzeichnet, dass**
der Lüfterträger (10) in der oberen Hälfte des Schaltschrankes, insbesondere einem oberen Drittel des Schaltschrankes, angeordnet ist.

## Claims

1. Set comprising the following:
a fan (16)
different, alternatively interchangeable inserts and a fan holder (10) for the fan (16),
wherein the inserts comprise a filter insert (24) and a flap device (21), which is provided with pivotably mounted flaps for closing an opening (27),
wherein the fan holder (10) comprises a frame (26) containing the opening (27), through which a gaseous medium can flow during operation and which forms an accommodating region (28), which is designed for alternatively accommodating the flap device (21) and the filter insert (24) and has at least one retaining means for fixing the respective insert.

2. Fan arrangement comprising
a fan (16) according to Claim 1,
a fan holder (10) according to Claim 1,
a cover (11), via which the accommodating region (28) of the fan holder (10) can be closed in the outward direction, e.g. by a front lattice (13),
and
a flap device (21) according to Claim 1,
wherein the flap device (21) is arranged in the accommodating region (28) such that it can be changed over for a filter insert (24) according to Claim 1, and wherein the flap device (21) is arranged between the fan (16) and the cover (11).

3. Set or fan arrangement according to Claim 1 or 2,
**characterized in that**
the opening (27) is delimited laterally by retaining surfaces (29), which retain the respective insert in the frame (26).

4. Set or fan arrangement according to one of Claims 1 to 3,
**characterized in that**
the accommodating region (28) has a retaining device, in particular at least one elastic element (30) or at least one latching nose, which subjects the respective insert to a retaining force during operation.

5. Set or fan arrangement according to Claim 4,
**characterized in that**
an elastic element (30) is arranged in each of the corners (31) of the accommodating region (28), said elastic elements connecting the retaining surfaces (29).

6. Set according to one of the preceding claims,
**characterized by** the provision of
a, preferably separable, cover (11), via which the fan holder, in particular the accommodating region (28) thereof, can be closed in the outward direction.

7. Set or fan arrangement according to Claim 6,
**characterized in that**
the cover (11) has a front lattice (13), which is designed in the form of a diffuser and has a plurality of through-slots (39) in particular with an elliptical cross section.

8. Set or fan arrangement according to one of the preceding claims,
**characterized in that**
the frame (26) forms an, in particular all-round, step (19), on which the cover (11) can be positioned.

9. Fan arrangement according to one of the preceding claims,
**characterized in that**
the fan (16) is connected to the fan holder (10) via a fan funnel (15).

10. Set or fan arrangement according to one of the preceding claims, wherein the flap device (21) comprises a flap frame (32), which can be, or has been, inserted into the accommodating region (28) of the fan holder and holds at least one, in particular more than one, flap (23).

11. Set or fan arrangement according to Claim 10,
**characterized in that**
the flaps (23) are closed when the fan (16) is in a switched-off state.

12. Set or fan arrangement according to Claim 10 or 11,
**characterized in that**
the flaps (23) are connected in a releasable manner to the flap frame (32).

13. Set or fan arrangement according to one of Claims 10 to 12,
**characterized in that**
a longitudinal axis (L) of the through-slots (39) is oriented essentially parallel to the flaps (23) in an open state.

14. Switch cabinet comprising a fan arrangement according to one of Claims 2 to 5, 7 to 13,
**characterized in that**
the fan holder (10) is arranged in the upper half of the switch cabinet, in particular in an upper third of the switch cabinet.

## Revendications

1. Ensemble comprenant ce qui suit:
- un ventilateur (16),
- différents éléments échangeables alternativement l'un par rapport à l'autre et un support de ventilateur (10) pour le ventilateur (16),
dans lequel les éléments comprennent un élément de filtre (24) et un dispositif à volets (21) muni de volets pivotants pour fermer une ouverture (27),
dans lequel le support de ventilateur (10) comprend un cadre (26) avec l'ouverture (27),
à travers laquelle en service un milieu gazeux peut circuler, et qui forme une région de logement (28), qui est configurée pour le logement alternatif du dispositif à volets (21) et de l'élément de filtre (24) et qui présente au moins un moyen de retenue pour la fixation de l'élément respectif.

2. Dispositif de ventilateur comprenant
- un ventilateur (16) selon la revendication 1,
- un support de ventilateur (10) selon la revendication 1,
- une hotte de recouvrement (11), par laquelle la région de logement (28) du support de ventilateur (10) peut être fermée vers l'extérieur, par exemple par une grille frontale (13)), et
- un dispositif à volets (21) selon la revendication 1, dans lequel le dispositif à volets (21) est disposé dans la région de logement (28) de façon échangeable contre un élément de filtre (24) selon la revendication 1, et dans lequel le dispositif à volets (21) est disposé entre le ventilateur (16) et la hotte de recouvrement (11).

3. Ensemble ou dispositif de ventilateur selon une revendication 1 ou 2, **caractérisé en ce que** l'ouverture (27) est limitée latéralement par des faces de retenue (29), qui retiennent l'élément respectif dans le cadre (26) .

4. Ensemble ou dispositif de ventilateur selon l'une quelconque des revendications 1 à 3, **caractérisé en ce que** la région de logement (28) présente un dispositif de retenue, en particulier un élément élastique (30) ou au moins un ergot d'encliquetage, qui exerce en service une force de retenue sur l'élément respectif.

5. Ensemble ou dispositif de ventilateur selon la revendication 4, **caractérisé en ce qu'**un élément élastique (30) est disposé respectivement dans les coins (31) de la région de logement (28), et relie les faces de retenue (29).

6. Ensemble selon l'une quelconque des revendications précédentes, **caractérisé en ce qu'**il est prévu une hotte de recouvrement (11), de préférence séparable, par laquelle le support de ventilateur, en particulier sa région de logement (28), peut être fermé(e) vers l'extérieur.

7. Ensemble ou dispositif de ventilateur selon la revendication 6, **caractérisé en ce que** la hotte de recouvrement (11) présente une grille frontale (13) réalisée en forme de diffuseur, qui présente plusieurs fentes de passage (39) en particulier avec une section transversale elliptique.

8. Ensemble ou dispositif de ventilateur selon l'une quelconque des revendications précédentes, **caractérisé en ce que** le cadre (26) forme un gradin (19), en particulier périphérique, sur lequel la hotte de recouvrement (11) peut être posée.

9. Dispositif de ventilateur selon l'une quelconque des revendications précédentes, **caractérisé en ce que** le ventilateur (16) est assemblé au support de ventilateur (10) par un entonnoir de ventilateur (15).

10. Ensemble ou dispositif de ventilateur selon l'une quelconque des revendications précédentes, dans lequel le dispositif à volets (21) comprend un cadre à volets (32), qui peut être ou est inséré dans la région de logement (28) du support de ventilateur, et qui porte au moins un, en particulier plusieurs volet(s) (23).

11. Ensemble ou dispositif de ventilateur selon la revendication 10, **caractérisé en ce que** les volets (23) sont fermés dans un état de fonctionnement interrompu du ventilateur (16).

12. Ensemble ou dispositif de ventilateur selon une revendication 10 ou 11, **caractérisé en ce que** les volets (23) sont assemblés de façon séparable au cadre à volets (32) .

13. Ensemble ou dispositif de ventilateur selon l'une quelconque des revendications 10 à 12, **caractérisé en ce qu'**un axe longitudinal (L) des fentes de passage (39) est dans un état ouvert orienté essentiellement parallèlement aux volets (23).

14. Armoire électrique, comprenant un dispositif de ventilateur selon l'une quelconque des revendications 2 à 5 ou 7 à 13, **caractérisée en ce que** le support de ventilateur (10) est disposé dans une moitié supérieure de l'armoire électrique, en particulier dans un tiers supérieur de l'armoire électrique.
